Europäisches Patentamt

European Patent Office

Office européen des brevets

(19)

(11) **EP 1 491 903 A1**

(12) **EUROPEAN PATENT APPLICATION**

(43) Date of publication:
**29.12.2004 Bulletin 2004/53**

(51) Int Cl.$^7$: **G01R 15/24**, G01R 35/00

(21) Application number: **03010594.4**

(22) Date of filing: **12.05.2003**

| | |
|---|---|
| (84) Designated Contracting States:<br>**AT BE BG CH CY CZ DE DK EE ES FI FR GB GR<br>HU IE IT LI LU MC NL PT RO SE SI SK TR**<br>Designated Extension States:<br>**AL LT LV MK**<br><br>(71) Applicant: **Kasmatic Innovation A/S<br>2800 Kgs. Lyngby (DK)** | (72) Inventor: **Bjoern, Lars, Noergaard<br>2700 Broenshoej (DK)**<br><br>(74) Representative: **Nielsen, Henrik Sten et al<br>Budde, Schou & Ostenfeld A/S<br>Vester Sögade 10<br>1601 Copenhagen V (DK)** |

(54) **Fiberoptic Faraday effect sensor**

(57) An electric current measurement device, comprises a housing defining first and second opposite open ends. A first sealing means has an aperture and an overall geometrical configuration corresponding to the overall geometrical configuration of the first open end of the housing, and further comprises an aperture adapted for receiving a first optical fibre. The device further comprises a first fixture means for fixating the first optical fibre, a first optical lens having a reception part adapted for receiving the first fixture means for mounting the first optical fibre in optical continuation with the first optical lens, which is mounted in the housing, and a first polarisation filter mounted in the housing in optical continuation with the first optical lens. A glass rod is received in and encapsulated within the housing in optical continuation with the first polarisation filter, and is constructed from a material having magneto-optical properties. The apparatus further comprises a second polarisation filter mounted in the housing in optical continuation with the glass rod, a second optical lens mounted in the housing in optical continuation with the second polarisation filter, and adapted for receiving a second fixture means, a second fixture means for fixating a second optical fibre, and received in the second optical lens, and a second sealing means for sealing the second end of the housing. The second sealing means has an aperture for receiving a second optical fibre, and is mounted in the second end of the housing end. A first and second lid are adapted for fixation to the first and second end, respectively, of the housing, and include an aperture for receiving the first and second optical fibre respectively.

Fig 1

EP 1 491 903 A1

**Description**

The invention relates to a Faraday optical current sensor with polarimetric detection. The present invention further relates to a method of calibrating a current sensor system including a Faraday optical current sensor.

The power industry has a need for monitoring transformer stations for power surges and measurement of large current pulses. For these purposes, a Faraday Effect current sensor has several advantages. A Faraday Effect current sensor may be constructed from dielectric materials, which is of grave importance when measuring at high currents in the presence of substantial electric magnetic interference. Faraday Effect current sensors may employ a coil of an optical fibre or a number of optical fibres, formed of a material exhibiting the Faraday Effect in response to a magnetic field generated by an electric current. A number of prior art patent publications describe Faraday optical current sensors, such as the US publications US 4,894,608, US 5,051,577, US 5,486,754, US 5,811,964, US 6,043,648, all of which are hereby incorporated in the present specification by reference.

In a Faraday Effect current sensor, a light source generates light, which is passed through a polarisation filter or otherwise polarised prior to travelling through the magneto-optical sensitive material. The polarised incident light undergoes a rotation, which is a function of the magnetic field created by the electrical current to be measured. The current to be measured may be determined by metering the angle of rotation of the polarisation plane of the light at the output of the Faraday optical current sensor.

The determination of the current to be measured is subject to a number of sources of error. Any system based on optics or electrical circuits are sensitive to noise and other signal degradations, such as optical noise or interference from electromagnetic sources. A system comprising a light source, a light detection unit and an optical conduit such as an optical fibre may suffer loss of sensitivity due to optical dampening caused by defects in material used to form an optical conduit or device such as lenses or optical fibres. Light sources and light detection circuitry may be exposed to electrical noise or interference from magnetic fields from nearby inductors or systems alternatively noise caused by fluctuations in the power supply.

Also environmental conditions such as temperature have an effect on material properties such as Verdets constant and also an effect on the noise generated in the light source and in the light detection circuitry. Furthermore, all electrical components and light sources and light detection elements suffer degradation over time. All the factors mentioned above contribute to a reduced precision of the measurements performed by the system.

A calibration prior to commencing measurements and monitoring of a transformer station by using a Faraday optical current sensor is contemplated to give a more precise determination of the current in the electrical conductor. Furthermore, a precise measurement depends on having a stable light source outputting a constant amount of light, alternatively determination of the change of the intensity of the light from the light source as well as light intensity changes caused by temperature variations.

A system for monitoring a transformer station may be fitted with a data collection and data transmission unit for transmitting the collected data to one or more computers monitoring a number of transformer stations. These communication units may be constituted by wireless connections or fixed connections such as POTS/PSTN networks. The communication from the measurement system mounted in the individual transformer stations to a central computer may include information on average loads, current peaks, actual current for the high voltage current lines, energy direction, maximum currents, actual voltages, ambient temperature and time stamps for all the above-mentioned information. Furthermore, the measurement system may include an alert function for alerting an operator in a power supply company about situations where the peak current is above a given maximum threshold, alternatively below a minimum threshold, a situation where the voltage is above maximum threshold, alternatively below a minimum threshold or other information such as ambient temperatures being out of range, all of which indicate some failure or fault in the transformer station.

The communication unit further provides the opportunity of performing a remote configuration of the system, giving an operator the possibility to configure the system, e.g. defining levels for peak currents, voltage drop out levels, time out values and alerting options.

The system outlined above may also be employed in industries such as windmills or in power plants such as coal driven or nuclear plants and is not limited to applications in transformer stations.

The present invention also relates to a method of calibrating a system for measuring high voltage current in electrical conductors, the method comprising:

    providing an electrical conductor carrying high voltage current,
    providing a light source,
    providing a first optical conduit defining a first and a second opposite end, said light source connected to said first end of said first optical conduit, said light source emitting light into said first optical conduit,
    providing a Faraday current measurement device defining a first and a second opposite end, said first end of said Faraday current measurement device connected to said second end of said first optical conduit, said Faraday current measurement device receiving said light from said first optical conduit,

providing a second optical conduit, defining a first and a second opposite end, said first end connected to said second end of said Faraday current measurement device,

providing an optical detection means for converting said light to an electrical signal, said optical detection means connected to said second end of said second optical conduit,

providing a current measurement system performing a measurement of the current in said electrical conductor,

performing said measurement of said electrical current in said electrical conductor, said system for measuring high voltage current in electrical conductors calculating a calibration constant, removing said current measurement system.

Preferably, the method of calibrating a system, further comprises:

said system for measuring high voltage current in electrical conductors periodically, alternatively aperiodically, recalculating said calibration constant by measuring the AC and DC components of said electrical signal.

According to a particular aspect of the present invention, the method further comprises the steps of initially determining the DC component of said optical signal, then periodically determining the DC component of said optical signal,

determining the actual AC component by multiplying the measured AC component with the ratio of said initially determined DC component and said periodically determinated DC component.

The method according to the present invention is preferably implemented using the Faraday current measurement device also according to the present invention.

The present invention is now to be further described with reference to the drawings in which

Fig 1 is a schematic cross-sectional view of a Faraday optical current sensor,
Fig 2 is a zoomed schematic cross-sectional view of a Faraday optical current sensor,
Fig 3 illustrated a groove in the housing of a Faraday optical current sensor,
Fig 4 is a schematic view of an end of a Faraday optical current sensor,
Fig 5 is a schematic view of an end of a Faraday optical current sensor,
Fig 6 is a schematic block diagram of a system for measuring electric current comprising a Faraday optical current sensor,
Fig 7 is a schematic view of the detection system that is a part of the system illustrated in Fig 6,
Fig 8 is a schematic cross-sectional view of a measurement set-up with three electrical conductors and one Faraday optical current sensor
Fig 9 illustrates a measurement set-up with a rectangular conductor,
Fig 10 illustrates a measurement set-up with a circular conductor,
Fig 11 illustrates a measurement set-up with a circular conductor with an insulating layer,
Fig 12 is a schematic block diagram of a prototype implementation of the detection system and processing unit of the system illustrated in Fig 6,
Figs 13 to 18 are schematically views of a prototype version of the present invention.

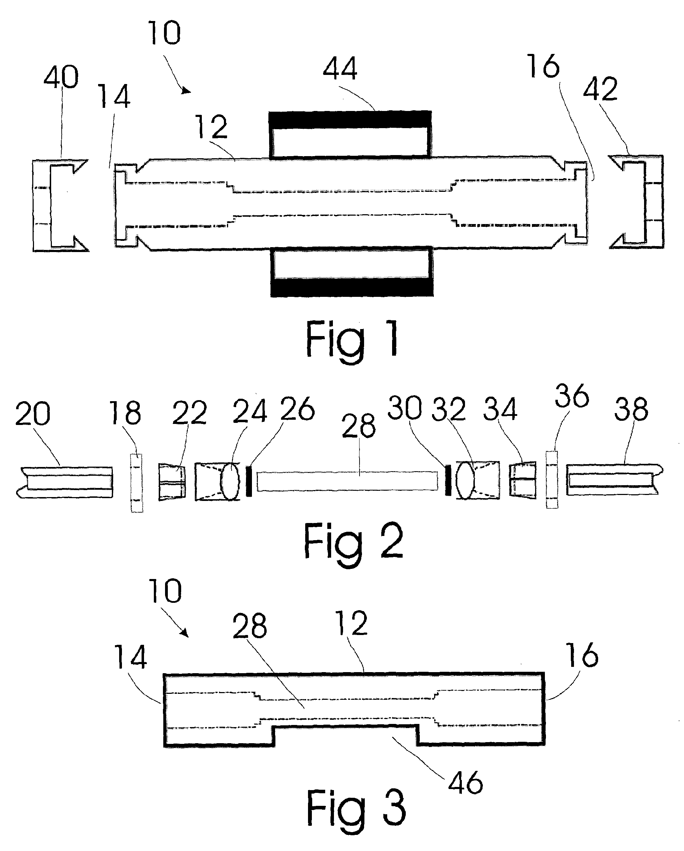

Fig. 1 is a schematic cross sectional view of a Faraday optical current sensor 10, and fig 2 is a zoomed schematic cross sectional view of the Faraday optical current sensor 10 of Fig 1. The Faraday optical current sensor 10 comprises an oblong housing 12 defining a first and an opposite second end; designated 14 and 16 respectively. At the first end 14 of the housing 12 a first sealing 18 is mounted, the first sealing 18 having an aperture for receiving a first optical fibre 20. A first fibre fixture 22 mounted in the housing 12. The first fibre fixture 22 having a aperture for receiving an optical fibre 20. An optical lens 24 having a receiving section for receiving the optical fibre 20 and the fibre fixture 22. A first polarisation filter 26 mounted in optical continuation with the optical lens 24. A glass rod 28 in optical continuation with the first polarisation filter 26. At the opposite end of the glass rod 28 a second polarisation filter 30 is mounted in optical continuation therewith. A second optical lens 32 is mounted in optical continuation with the second polarisation filter 30. The second optical lens 32 including a receiving section for receiving a second fibre fixture 34. A second sealing 36 having an aperture for receiving a second optical fibre 38.

Two optical fibres 20, 38 are inserted through the first and second sealings 18,36 into the first and second fibre fixtures 22,34, respectively. The optical fibres 20, 38 are mechanically fixated to the housing 12 by means of two sensor lids 40,42, respectively. The sensor lids 40,42 fixate the fibres 20, 38 and seals the Faraday optical current sensor 10.

The material used to mould the sensor lids 56,58 is preferably a plastic material able to withstand temperature ranges from -40 to 150°C and have an electrical isolating property. The material is preferably non-permeable to light in the 400 to 1000 nm range. Materials with the above mentioned properties may be a plastic materials such as Ultem or Peek.

The housing 12 may further comprise a set of wings 44 for the mounting of the Faraday optical current sensor 10 to an electrical conductor by plastic strips or other fastening means.

Fig. 3 is a schematic side view of a faraday optical current sensor 10 illustrating a groove 46 in the housing 12 extending parallel with the glass rod 28. The groove 46 may have a planar bottom wall or alternatively a rounded bottom wall for improving the fixation of the Faraday optical current sensor 10 to an electrical conductor. The groove 46 is incorporated in the housing in order to bring the glass rod 28 as close to the electrical conductor as possible and have the further advantage of fixating the Faraday optical current sensor 10 at a 90-degree angle with respect to the electrical conductor. The width of the groove 46 may be arbitrary but preferably have the same or shorter length than the length of the glass rod 28. The fixation wings 44 may be incorporated in a geometrical expansion of the groove 46.

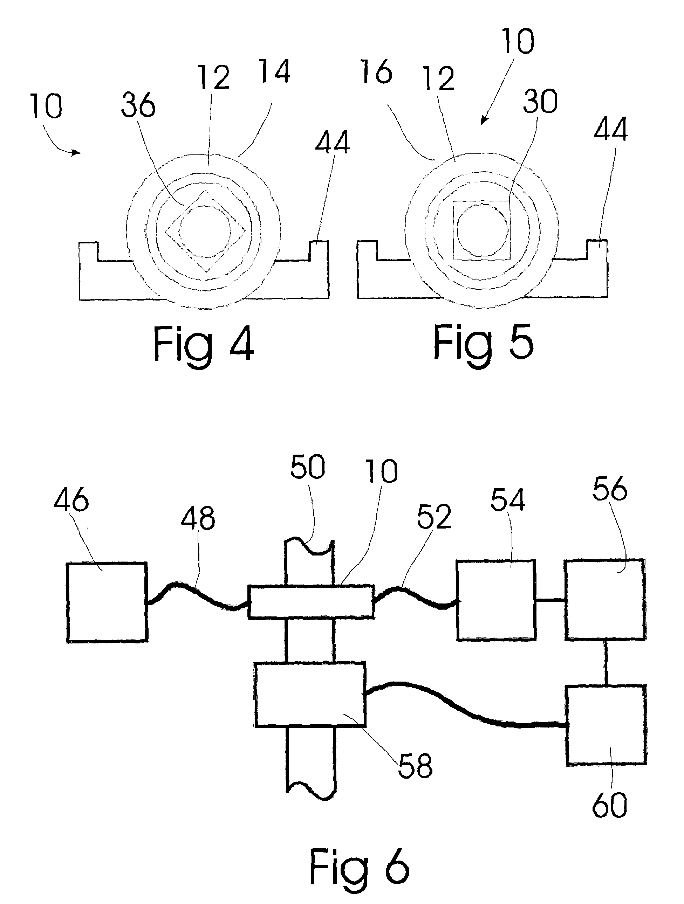

Fig. 4 is a schematic view of one end 14 of the Faraday optical current sensor 10. The Figure illustrates the first polarisation filter 26 mounted in the housing 12.

Fig. 5 is a schematic view of the opposite end of the Faraday optical current sensor 10 illustrated in Fig. 4. The Figure further illustrates the second polarisation filter 30 mounted in the housing 12 rotated 45° with respect to the first polarisation filter 26. The geometrical configuration of the polarisation filters are illustrated as square, alternatively, the filters may have any geometrical configuration as long as the polarisation planes of the two polarisation filters are rotated 45°, respectively.

A prototype version of the Faraday optical current sensor 10 having the following mechanical dimensions has been constructed. The overall length of the housing 12 is 65 mm and the diameter 12,6 mm. The opening for receiving the fibre is 7,5 mm. The wings 44 have an overall size of 11,6 mm x 40 mm from end to end. The groove has a length of 45 mm. The glass rod has a length of 35 mm and a diameter of 4 mm. The polarisation filters are square, with each of the sides being 5,3 mm.

Fig. 6 is a schematic view of a system for measuring electric current in a conductor by utilising the Faraday effect in a magneto-optical transducer. The system comprises a light source 46. The light source may be a light bulb or an LED based light source. The light emitted from the light source 46 is guided through a first optical conductor 48, such as an optical fibre. The optical conductor 48 is connected to a Faraday optical current sensor 16 comprising two polarisation filters 26, 30 and a magneto-optical material. The polarisation filters 26, 30 are rotated 45° respectively. The Faraday optical current sensor 10 is mounted on an electrical conductor 50 wherein a high voltage current flows, such as 10 kV. The output end of the Faraday optical current sensor 10 is connected to a second optical conductor 18, such as an optical fibre. The second optical conductor 18 is connected to a detection system 54, which converts the analogue optical signal to a digital signal. The digital signal from the detection system 54 is provided to a signal-processing unit 56, which performs a number of calculations on the data. A measurement device 58 is mounted on the electrical conductor 50 for calibration purposes. The measurement device 58 is connected to a current measurement system 60 providing additional data to the signal-processing unit 56.

The signal-processing unit 56 compares, stores and performs calculations on the data from the detection system 54 and the data from the current measurement system 60.

Calibration of the system requires the signal processing unit 56 to compare data from the detection system 54 and the current measurement system 60, the signal processing unit then stores these data. At the end of the calibration the stored data from each of the devices are summed up. The summed up data from the current measurement system 60 is divided with the summed up data from the detection system 54. The result of this division is used as a calibration value, the calibration value is stored in the signal processing unit 56. The current measurement system 60 and the measurement device 58 may be dismounted from the set-up.

The set-up illustrated in Fig. 6 having a light source 46, and Faraday optical current sensor 10 and an optical detection system 54 are sensitive to electrical noise in the light source 46, optical noise in the detection unit 54 and interference from magnetic fields from nearby inductors and systems. The mounting and the set-up of the sensor 10 as well as the shape and the diameter of the conductor to be measured have an influence on the measurements performed by the system. The system may be used in a variety of locations around the world where temperature variations may occur often. The temperature may affect the operation of the light source 46 and the detector circuit in the detection system 54. Furthermore, the light source 46 and the detection system 54 as well as other components in the system may suffer to degradation over operation and product lifetime. A precise measurement depends on a stabile light source and determining the compensation factors for the implemented system as well as recording changes in light source output, long term variations of the detection system and variation in temperature of the surrounding environment.

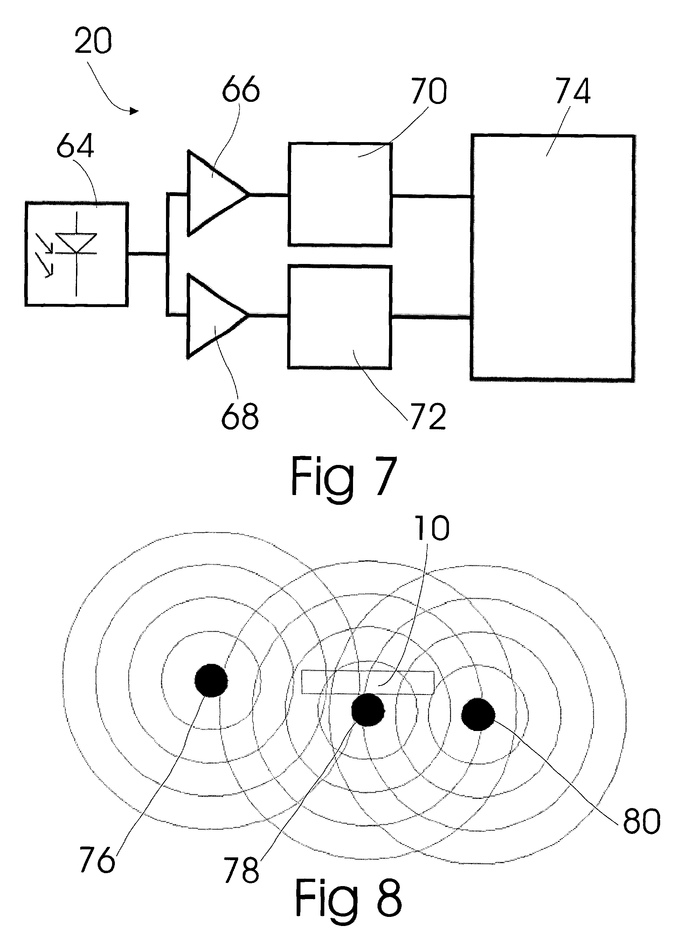

Fig. 7 is a schematic view of the detection system 54 of the current measurement system. The detection system comprises a light sensitive component 64 that converts the light received by the detection system 54 from the light conduit 18. The light sensitive component 64 converts the light to an electrical signal. The electrical signal comprises an AC and a DC component, the signal is divided in two and provided to two amplifiers 66, 68 and the amplified signal from the amplifier 66 is supplied to a DC separator 70 separating the DC component from the amplified signal. The amplified signal from the amplifier 68 is supplied to an AC separator 72 separating the AC component from the amplified signal. The analogue signal processing unit 74 converts the DC separated signal and the AC separated signal from analogue signals to digital signals. The DC signal is compared to a stored DC signal value measured during calibration of the system. The percentage change from the calibrated DC component is multiplied to the AC component. The signal from an optic Faraday effect sensor comprises a DC and an AC component. The AC component arises when a time-varying magnetic field is applied to Faraday optical current sensor 10. The DC component arises if a DC or a non-magnetic field is applied to the Faraday optical current sensor 10, if the AC signal includes a DC component, long-term variations of the detection system and variations in temperature of the surroundings.

Fig. 8 is a schematic, cross sectional view of a set-up with three electrical conductors 76, 78, 80, each being a high voltage conductor. The concentric circles around each of the conductors represent the electromagnetic field radiated therefrom, illustrating that measurements on electromagnetic fields emitted from one conductor 78 by a sensor 10 may be influenced by fields radiated from other electrical conductors 76, 80. The calibration process is performed in order to eliminate the interference from neighbouring conductors and other electromagnetic fields in the surroundings influencing the sensor 10. These other magnetic fields may originate from electrical equipment within a transformer station in which the sensor is mounted, or fields radiated from the electrical conductor on which the sensor is mounted being reflected from the interior of the transformer station, alternatively reflected electromagnetic fields emitted from neighbouring electrical conductors.

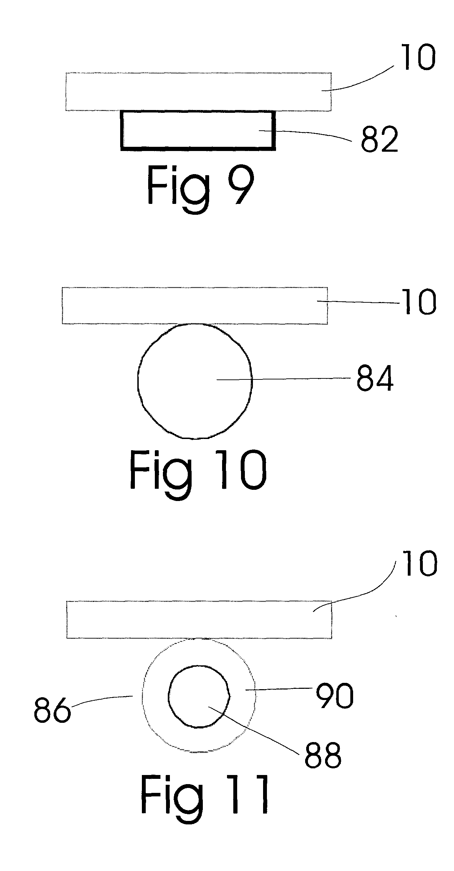

Fig. 9 illustrates a set-up with a Faraday optical current sensor 10 mounted on a rectangular conductor 82.

Fig. 10 illustrates a Faraday optical current sensor 10 mounted directly to a circular conductor 84.

Fig. 11 is a schematic cross sectional view of a Faraday optical current sensor 10 mounted on a circular conductor 86 having a conductive core 88 and an insulator layer 90 arranged surrounding the perimeter of the electrically conductive core 88. The Faraday optical current sensor 10 is a point measurement sensor, and the shape of the B-field and the distance between the inductor are parameters to be considered. The on-site calibration of the sensor system compensates for the B-field shaped variations and the distance from the inductor, as well as static electromagnetic fields present, originating from other sources.

The amplitude of the DC component where no magnetic field is applied to the Faraday optical current sensor 10 depends on the intensity of the light emitted from the light source, the resistance through the optic system and the detector circuit.

The AC and DC components of the signal have a linear correlation where no DC magnetic field is applied to the optic Faraday effect current sensor.

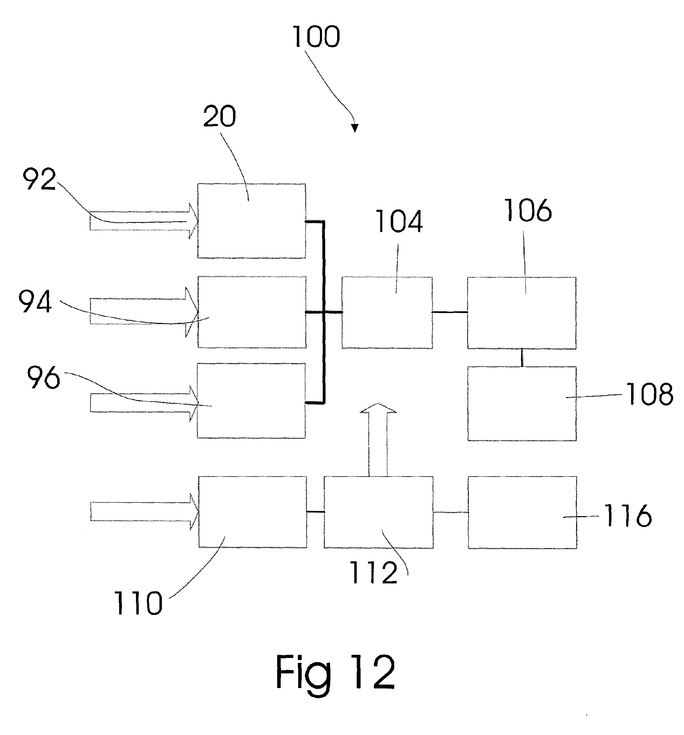

Fig. 12 is a schematic block diagram of a prototype implementation of the detection system 20 and signal-processing unit 22 of Fig. 6. The module 100 includes the sensor inputs 92 inputting the signal from the Faraday optic current sensor 10 to the detection system 20 illustrated in detail in Fig. 7. A number of optocouplers corresponding to the number of low voltage drop lines are used to determine the voltage on the voltage drop lines, these voltages being in the range of 400 volts AC. The module further includes a user interface input-output port 96 in the prototype implementation, the input-output 96 in the prototype version is an RS-232 serial communications port. The input-output port 96 is connected to a user interface module 106, used in the set-up and initial calibration of the system.

The data from the detection system 20 and the 400 AC module 98 are sent to a signal and data processing unit 104, which performs a face matching for determining the face angle between the current and the voltage. In a prototype implementation of the measurement system, the signal and data processing unit have been implemented as an embedded dual processor application. The system functionality is split into a measurement part and a communication part. The measurement part handles the scanning of 6 current channels, the scanning of 3 voltage channels and the calculations on the collected data.

The module further comprises a communication module 106 for communicating the data collected by the data processing unit of the processor unit 104. As the system may be installed in a remote location and used for automatic surveillance of the operation of a transformer station, the system may be connected to a central data collection site collecting data from a number of transformer stations for the safe operation of an electrical distribution network. The communication module 106 may be constituted by a module adapted for converting the data from the data processing unit 104 to a communication protocols such as GSM and/or ISDN, alternatively a data communication protocol, such as TCP/IP. The module further includes a transmitter unit 108, which, in case of the communications module being a GSM module is an antenna, alternatively a local area network port or the like. The module 100 further includes a power supply 110 supplying the module with electrical power. The power is supplied to a power management unit 112 dividing the power as system power and for charging a battery module 114 for the safe operation of the module 100 is case of power failure.

In the prototype implementation of the module 100, the protocol for communication the status of the transformer station is described in detail below in a number of tables.

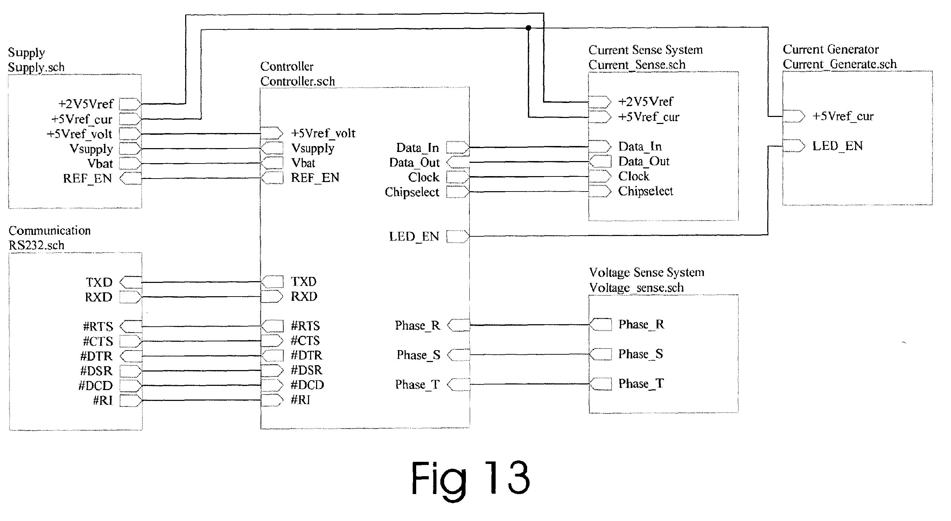

Figures 13 to 18 are schematic block diagrams of a prototype version according to the present invention. All components are described by name and product number in the illustrations, and are considered to be self-explanatory when taking in to account the descriptions above.

Fig 13 is a schematic block diagram of a prototype version of a 10 kVSS according to the present invention.

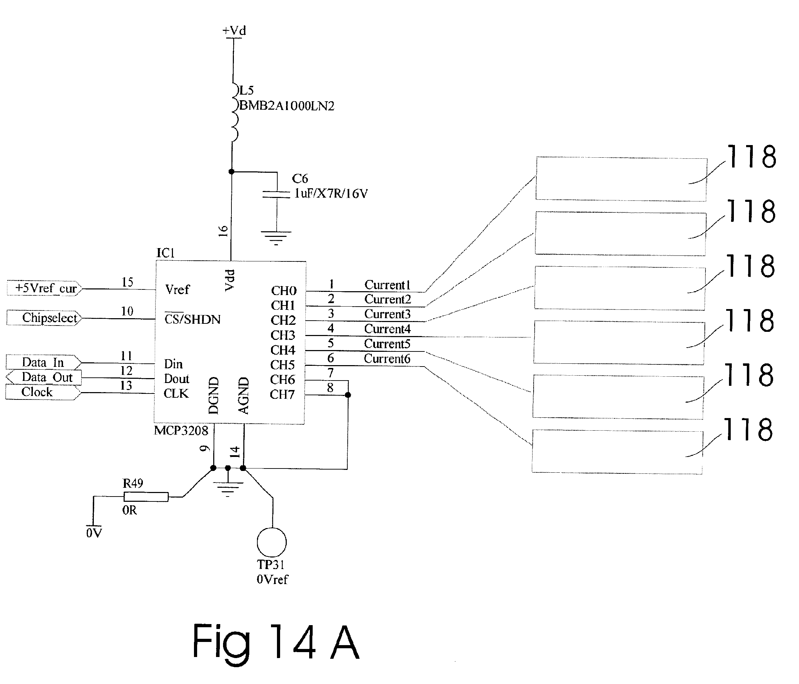

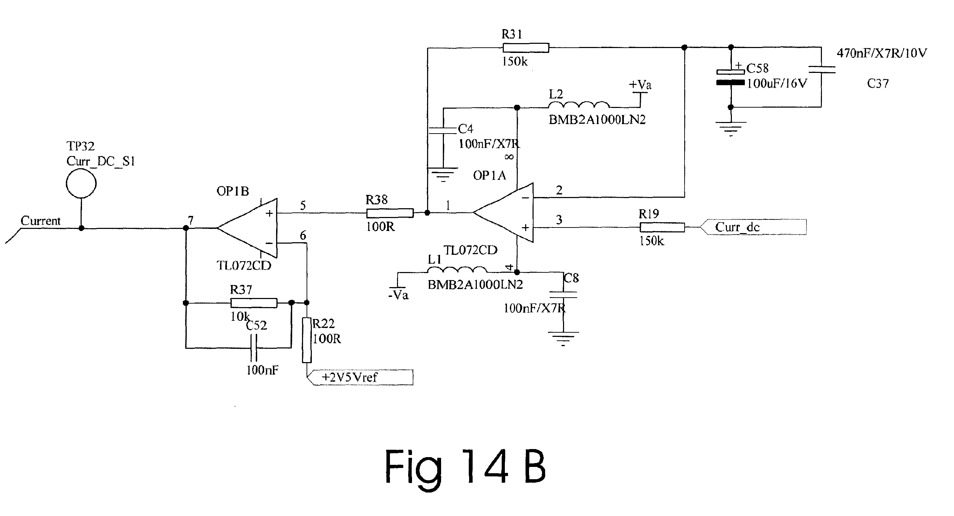

Fig. 14 A is a schematic block diagram of a DC current sensor. In the prototype version the DC sensor have 6 channels, each channel being supplied with a signal from a sensor circuit illustrated in detail in Fig 14 B.

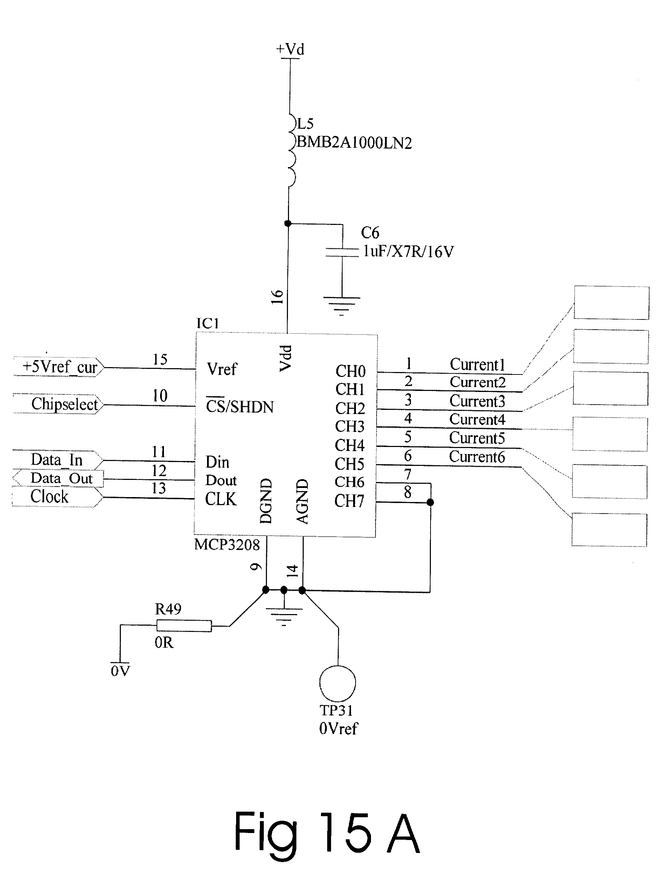

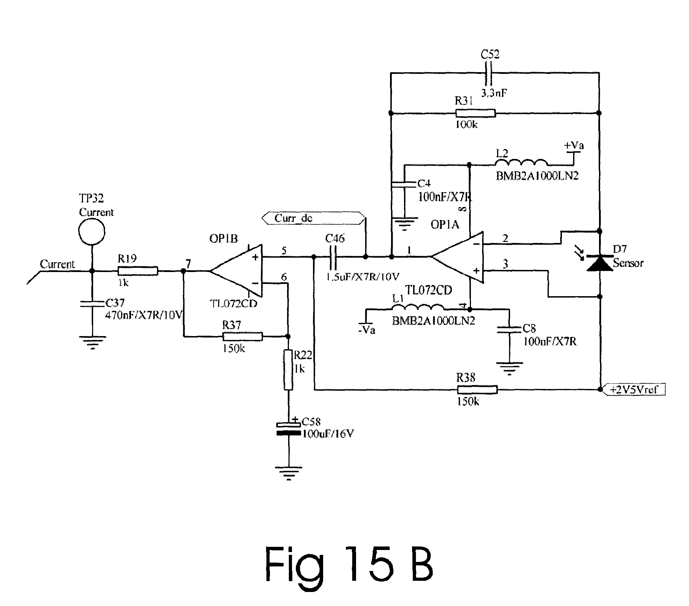

Fig. 15 A is a schematic block diagram of a current sensor. In the prototype version the sensor have 6 channels, each channel being supplied with a signal from a sensor circuit illustrated in detail in Fig 15 B.

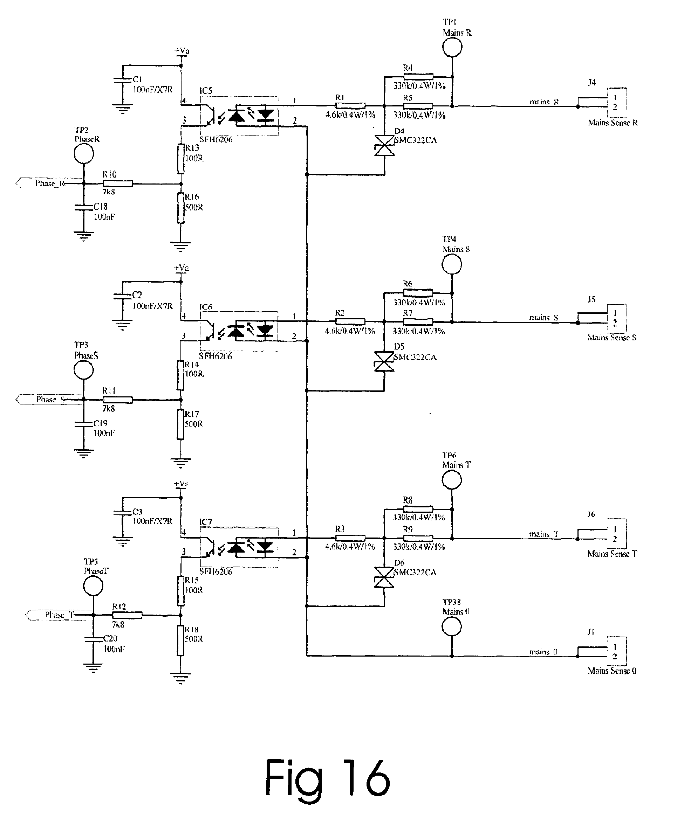

Fig. 16 is a schematic block diagram of a voltage sensor circuit.

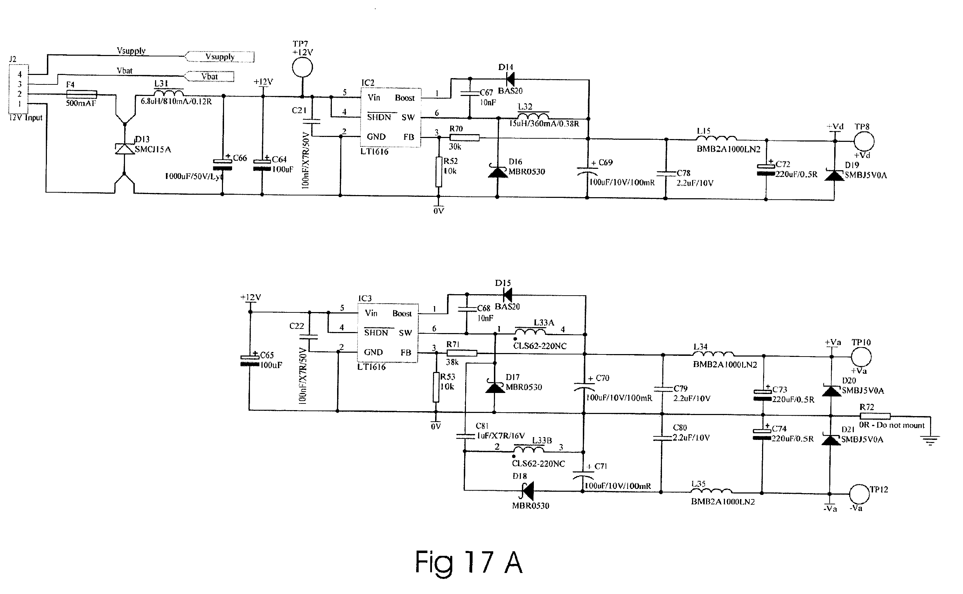

Fig. 17 A is a schematic block diagram illustrating a power management circuit.

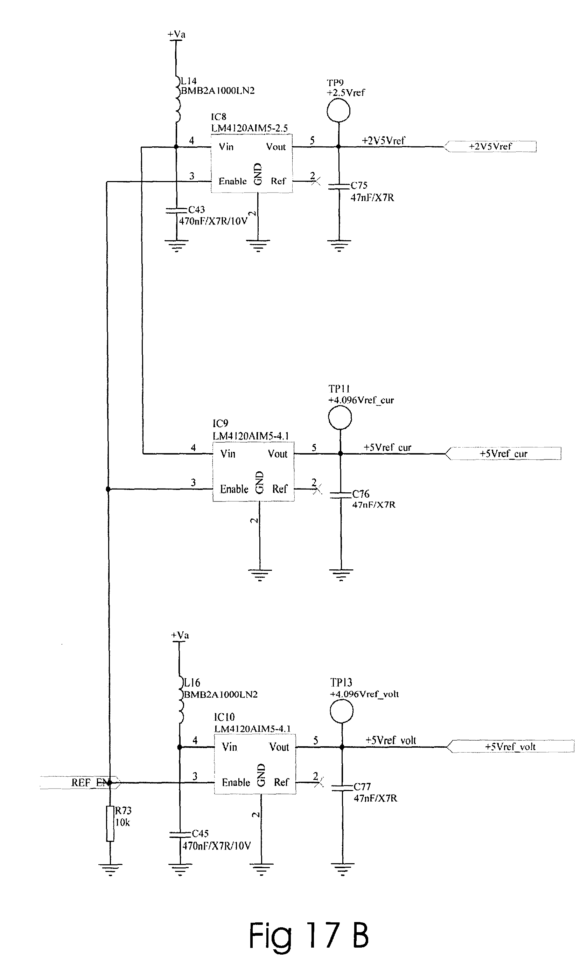

Fig. 17 B is a schematic block diagram illustrating a power management circuit cooperating with the power management circuit illustrated in fig 17 A.

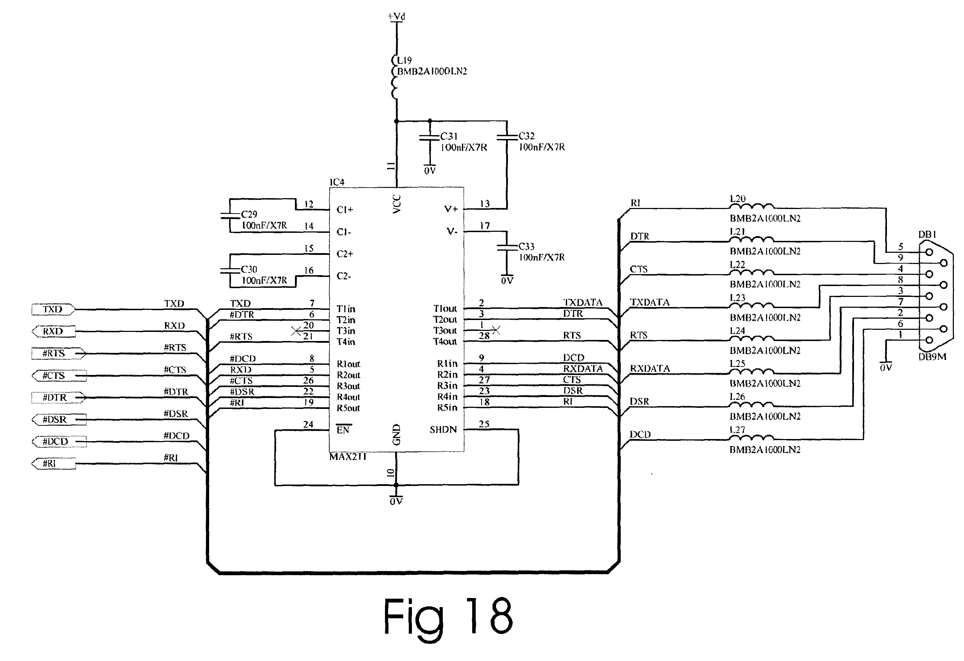

Fig. 18 is a schematic block diagram of an RS-232 communications port and the signals relating thereto.

Theoretical background of the invention.

When a simple fibre-optic Faraday Effect sensor is mounted on a conductor for example in a transformer station or on an installation cable, the output optic signal is sensitive for interference from magnetic fields from nearby systems, conductor shape, sensor placement and distance to conductor. The output optic signal is also sensitive to system mounting and set-up.

The object of this invention is to achieve an accurate device for measuring an electric current by the Faraday Effect, by compensating on-site for interference from magnetic fields from nearby inductors, conductor shape, distance from measuring device to conductor, and also mounting and setup.

This object is achieved by comparing data measured by the fibre-optic system with a third party current measurement system during set-up of the system on-site.

The B-field measured by the fibre-optic system is named $B_{measured}$. The actual current is determined according to the equation:

$$I_{actual} = K_{Calib} * B_{measured} \ [A]$$

$$\text{Were } K_{Calib} = \sum_{0}^{n} (I_{\text{Measured on third party system}}) \ / \sum_{0}^{n} (B_{\text{Measured on optic system}})$$

This calibration method compromises for linear magnetic field interference from nearby inductors, and the conversion factor between the B-field and current. It also compromises for production tolerances, conductor shape, conductor diameter and background noise, all when mounted in the active application.

After the calibration, the third party system is removed, and the fibre-optic current measurement system is a stand-alone measurement system.

In the addition to use the sensor at all, it is crucial to be calibrated on-site. A third party measurement device is used to measure the electrical current. This device can be a current coil or other current measurement devices that is calibrated, and for which the surrounding field can be ignored. The signal or data from the third party current measurement device is computed in a third party measurement system and send to the signal-processing unit.

The signal-processing unit compares the data from the two devices and store the data. After a certain period, the calibration is stopped and the stored data from each device is summed up. The summed up data from the third party current measurement system is divided with the summed up data from the optic sensor. This value is used as a calibration value and is stored in the signal-processing unit. The third party measurement system and device can be dismounted. The optic system has now an accurate calibration value for the application it is mounted on.

In a set-up with 3 conductors the magnetic field from nearby conductors may affect the measurement. On an inductor a fibre-optic Faraday Effect sensor is mounted. The magnetic fields from all 3 conductors affect the sensor. The B-field measured by a sensor x is:

$$B_{sum\_sensor\_x} = B_{L1} + B_{L2} + B_{L3}$$

During calibration $B_{sum\_sensor\_x}$ is compared with the data from the third part measurement device. From this calibration the calibration constant $K_{Calib}$ is determined. This constant contains the contribution from all 3 phases, means that the constant only is valid for a linear B-field.

The B-field is relatively known for a circular conductor, but the B-field is not known for a rectangular conductor. The fibre-optic Faraday Effect sensor creates only a point measurement, this means that the shape of the B-field and distance from the inductor is a crucial parameter. The on-site calibrations of the sensor compensates for the different B-field shape and distance from the inductor.

The signal from an optic Faraday Effect current sensor consist of an ac and dc component. The ac component exists when the time varying magnetic field is applied to the sensor. The DC component exists if a DC or a non-magnetic field is applied to the sensor.

The object of this invention is to achieve an accurate device for measuring an electric current in AC system, by the Faraday Effect, by electrically measuring the AC and DC component, to compensate via software for degradation of system optics over time. This compensation is bound in the compensation described above.

The size of the DC component, when no magnetic field is applied to the sensor depends on the output of the light exposed from the light source, the "light resistance" through the optic system, and the detector circuit. There is a linear coherence between the ac- and dc-component of the signal, assuming that there is no DC magnetic field applied to the sensor, no long term variations of the detection system and no variation in the temperature of the surrounding environment.

The compensated optical signal, $U_{ac\_actual}$ , is determined by:

$$U_{ac\_actual} = (U_{dc\_calib} / U_{dc\_actual}) \, U_{ac\_measured}$$

Were:

$U_{ac\_actual}$ is the compensated optic ac signal,
$U_{dc\_actual}$ is the actual measured dc component,
$U_{dc\_calib}$ is the dc signal measured when system was calibrated,
$U_{ac\_measured}$ is the actual measured optic ac signal.

The equation above show how to compensate for changes in the dc component due to optic changes, temperature, change of performance for light source, change of performance for detector, change of optical resistance in sensor due to life-time.

The following is a description of a prototype version of the present invention.

In a prototype version of the present invention a system measuring the actual current in and out of the transformer station plus the 400V voltage, reports the measured values via SMS messages over a GSM-modem.

The measured values could be: Actual current (averaged over the last second) for all channels, peak current with direction and timestamp for all channels, 400 V status with timestamp for last dropout, system condition.

Values are send to a service technician, alternatively to a server, on request and when alarm limits is exceeded.

More or less complex calculations may be implemented, as well as sampling rates, number of current channels etc may vary. The basic building blocks is the current calculation, the calibration and the correction according to the DC signal.

A prototype version of the present invention includes a processor system with embedded software or firmware. The main task for the firmware of the system may be divided into a number of tasks: Measurement and linearisation of current flow, calculation of current direction, correction according to DC signal and communication with server or service personal.

In the prototype version of the present invention six current channels and three voltage channels are feed into the processor system comprising the firmware through an optocoupler and an AD-converter. The phase between the current and the voltage is used to determine the direction of the current.

Each current channel of the system is principally constructed from an amplifier and filter part followed by an AD-converter. When the signal has passed the AD-converter the firmware performs of all the post-processing of the signal.

Each current channel is divided into two signals: The AC current signal and the DC component, both of which are feed through the AD converter. The optical current signal ($U_{AC}$) is used to calculate the actual current. The DC component of the optical current signal is used to calculate the degeneration factor.

The DC Signal ($U_{DC}$) from the optical sensor combined with the DC component is used to calculate the degeneration factor, and from that, the actual calibration constant ($K_{Calib}$).

$$U_{RMS} = \Sigma \, | \, U_{AC} - V_{REF} \, |$$

$$I_{RMS} = K_{Calib} \times U_{RMS}$$

The DC component of the signal is removed and the RMS value is calculated as the integral of the numerical value. The value is multiplied by the calibration constant ($K_{Calib}$) and the result is the current flowing in the actual channel.

The calculation is done for every 50Hz period. The post-processing of the result is done by the communication part of the system.

Detection, or determination, of the current direction is done through measuring the phase angle between the current and the voltage for the actual channel.

The phase angle depends on the type of load and the direction of the current. The type of load for the actual transformer station is chosen during calibration. If the phase difference, during an inductor load, is between -90° and +90° the current direction is positive.

The current phase is grasped from the optical sensors on the 10kV line. The voltage phase is captured from the 400V line, due to the fact that the 10kV voltage is not monitored.

The voltage phase is delayed through the transformation from 10kV to 400V. Therefore the phase is modified with 30° times the transformer factor.

The firmware in the system compensates for the degeneration of the system by looking on the DC component of the signal. This is done through correction of the initial calibration constant with the degeneration factor.

$$U_{AC,DC} = \Sigma \, U_{AC} - V_{REF}$$

$$U_{DC,AVR} = (\Sigma \, U_{DC}) \, / \, n, \text{ where } U_{DC} \text{ is summed up from 0 to n samples.}$$

$$K_{Calib} = (K_{Calib,Init} \times U_{DC,Init}) \, / \, (U_{DC} - U_{AC,DC})$$

The DC component of the measured AC value is subtracted from the measured DC signal to remove the DC component of the current flowing in the inductor.

Both $U_{DC}$ and $U_{AC}$ are sampled over a long period (e.g. one minute).

Besides using the calibration constant calculating the actual current, it also used as an indication of the overall system condition. The monitoring of this is done in the communication part.

After calculation of the actual currents and directions the measuring system takes care of the system specific calculations. These will vary from one implementation to another.

## Claims

**1.** An electric current measurement device, comprising:

a housing defining a first open end and a second open end opposite said first open end,
a first sealing means having an aperture, said first sealing means having an overall geometrical configuration corresponding to the overall geometrical configuration of said first open end of said housing, said first sealing means further comprising an aperture adapted for receiving a first optical fibre,
a first fixture means for fixating said first optical fibre,
a first optical lens having a reception part adapted for receiving said first fixture means for mounting said first optical fibre in optical continuation with said first optical lens, said first optical lens mounted in said housing,
a first polarisation filter mounted in said housing in optical continuation with said first optical lens,
a glass rod received in and encapsulated within said housing in optical continuation with said first polarisation filter, said glass rod being constructed from a material having magneto-optical properties,
a second polarisation filter mounted in said housing in optical continuation with said glass rod,
a second optical lens mounted in said housing in optical continuation with said second polarisation filter, said second optical lens adapted for receiving a second fixture means,
a second fixture means for fixating a second optical fibre, said second fixture means received in said second optical lens,
a second sealing means for sealing said second end of said housing, said second sealing means having an aperture for receiving a second optical fibre, said second sealing means mounted in said second end of said housing end, and

a first and second lid adapted for fixation to said first and second end, respectively, of said housing, said first and second lid including an aperture for receiving said first and second optical fibre respectively.

2. An electric current measurement device according to claim 1 wherein:

said first and said second polarisation filters are mounted in substantially parallel relation,
polarisation planes of said first polarisation filter and said second polarisation filter are rotated 45°, respectively.

3. An electric current measurement device according to any of the preceding claims,
said glass rod being made from SF6.

4. An electric current measurement device according to any of the preceding claims,
said housing being made from a material exhibiting optical non-transparency within the range at least 400 nm to 1000 nm.

5. An electric current measurement device according to any of the preceding claims,
said housing being made from Ulterm, alternatively Peek.

6. An electric current measurement device according to any of the preceding claims, said current measurement device further comprising:

a groove in said housing, said groove formed in said housing and having a width corresponding to the length of said glass rod mounted in said housing, alternatively, said groove being adapted for receiving an electrical conductor.

7. An electric current measurement device according to any of the preceding claims, said current measurement device further comprising:

at least one wing extending from said housing, said wing enabling said housing to be mounted on a oblong electrical conductor.

8. A system for measuring high voltage current in electrical conductors, said system comprising:

a light source, said light source being an LED based light source, alternatively an incandescent light source,
a first optical conduit being a first optical fibre, said first optical conduit conducting light emitted from said light source,
an optical electric current measurement device comprising:

a housing defining a first open end and a second open end opposite said first open end,
a first sealing means having an aperture, said first sealing means having an overall geometrical configuration corresponding to the overall geometrical configuration of said first open end of said housing, said first sealing means further comprising an aperture adapted for receiving said first optical fibre,
a first fixture means for fixating said first optical fibre,
a first optical lens having a reception part adapted for receiving said first fixture means for mounting said first optical fibre in optical continuation with said first optical lens, said first optical lens mounted in said housing,
a first polarisation filter mounted in said housing in optical continuation with said first optical lens,
a glass rod received in and encapsulated within said housing in optical continuation with said first polarisation filter, said glass rod being constructed from a material having magneto-optical properties,
a second polarisation filter mounted in said housing in optical continuation with said glass rod,
a second optical lens mounted in said housing in optical continuation with said second polarisation filter, said second optical lens adapted for receiving a second fixture means,
a second fixture means for fixating a second optical fibre, said second fixture means received in said second optical lens,
a second sealing means for sealing said second end of said housing, said second sealing means having an aperture for receiving a second optical fibre, said second sealing means mounted in said second end of said housing end, and a first and second lid adapted for fixation to said first and second end, respectively, of said housing, said first and second lid including an aperture for receiving said first and second optical fibre respectively, said optical electric current measurement device receiving said light from said first optical conduit,

a second optical conduit being said second optical fibre, said second optical conduit receiving said light emitted from said optical electric current measurement device,

a detection means for detecting said light emitted from said second optical conduit and converting said received light to an electrical signal,

a processing means for processing said electrical signal from said detection means,

a current measurement system for performing calibration measurements for said system, and

a first communications means.

9. A system for measuring high voltage current in electrical conductors according to claim 8, said system further comprising:

a computer connected to a second communication means, said computer located in a central location, and said computer including a interface for communicating status of a system for measuring high voltage current in electrical conductors to an operator.

10. A system for measuring high voltage current in electrical conductors according to claim 8, wherein:

said first and second communication means being a communications network, such as the Internet, a local area network, a wireless local area network, a wide area network, a global area network or a publicly switch telephone network, alternatively said first and said second communication means constituted by a fixed wireless network.

11. A method of calibrating a system for measuring high voltage current in electrical conductors, said method comprising:

providing an electrical conductor carrying high voltage current,

providing a light source,

providing a first optical conduit defining a first and a second opposite end, said light source connected to said first end of said first optical conduit, said light source emitting light into said first optical conduit,

providing a Faraday current measurement device defining a first and a second opposite end, said first end of said Faraday current measurement device connected to said second end of said first optical conduit, said Faraday current measurement device receiving said light from said first optical conduit,

providing a second optical conduit, defining a first and a second opposite end, said first end connected to said second end of said Faraday current measurement device,

providing an optical detection means for converting said light to an electrical signal, said optical detection means connected to said second end of said second optical conduit,

providing a current measurement system performing a measurement of the current in said electrical conductor, performing said measurement of said electrical current in said electrical conductor, said system for measuring high voltage current in electrical conductors calculating a calibration constant, removing said current measurement system.

12. A method according to claim 11, said method further comprising:

said system for measuring high voltage current in electrical conductors periodically, alternatively aperiodically, recalculating said calibration constant by measuring the AC and DC components of said electrical signal.

13. A method according to any of the claims 11 or 12, said method further comprising the steps of initially determining the DC component of said optical signal, then periodically determining the DC component of said optical signal, determining the actual AC component by multiplying the measured AC component with the ratio of said initially determined DC component and said periodically determinated DC component.

14. A method according to any of the claims 11 or 12, wherein said Faraday current measurement device is a device according to any of the claims 1 to 7.

10

40  14    12    44    16    42

Fig 1

20    18    22  24  26    28    30  32  34    36    38

Fig 2

10

14    28    12    16

46

Fig 3

Fig 4

Fig 5

Fig 6

Fig 7

Fig 8

Fig 9

Fig 10

Fig 11

Fig 12

Fig 13

Fig 14A

Fig 14 B

EP 1 491 903 A1

+Vd

L5
BMB2A1000LN2

C6
1uF/X7R/16V

IC1

+5Vref_cur — 15 — Vref

Chipselect — 10 — $\overline{CS}$/SHDN

Data_In — 11 — Din

Data_Out — 12 — Dout

Clock — 13 — CLK

16 — Vdd

CH0 — 1 — Current1
CH1 — 2 — Current2
CH2 — 3 — Current3
CH3 — 4 — Current4
CH4 — 5 — Current5
CH5 — 6 — Current6
CH6 — 7
CH7 — 8

DGND — 9
AGND — 14

MCP3208

R49
0R

0V

TP31
0Vref

# Fig 15 A

Fig 15 B

Fig 16

Fig 17 B

Fig 18

**European Patent Office**

## EUROPEAN SEARCH REPORT

Application Number

EP 03 01 0594

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | PATENT ABSTRACTS OF JAPAN vol. 1998, no. 10, 31 August 1998 (1998-08-31) & JP 10 123226 A (SUMITOMO METAL MINING CO LTD), 15 May 1998 (1998-05-15) * abstract * | 1-12,14 | G01R15/24 G01R35/00 |
| Y | US 6 349 165 B1 (LOCK WILLIAM E) 19 February 2002 (2002-02-19) * abstract * * column 5, line 10 - line 35 * * figure 7 * | 1-10 | |
| A | US 5 486 754 A (CRUDEN ANDREW J ET AL) 23 January 1996 (1996-01-23) * column 2, line 10 - line 52 * * figure 1 * | 8-10 | |
| A | US 4 676 589 A (MARUYAMA RYOJI ET AL) 30 June 1987 (1987-06-30) * figures 1,4 * | 1 | |
| Y | MENKE P ET AL: "TEMPERATURE COMPENSATION IN MAGNETOOPTIC AC CURRENT SENSORS USING AN INTELLIGENT AC-DC SIGNAL EVALUATION" JOURNAL OF LIGHTWAVE TECHNOLOGY, IEEE. NEW YORK, US, vol. 13, no. 7, 1 July 1995 (1995-07-01), pages 1362-1370, XP000597658 ISSN: 0733-8724 | 11,12,14 | TECHNICAL FIELDS SEARCHED (Int.Cl.7) G01R G02B G02F |
| A | * page 1364, column 1, paragraph 2 - page 1366, column 2, paragraph 3 * * figures 6,7 * | 13 | |
| Y | US 6 265 862 B1 (MENKE PETER) 24 July 2001 (2001-07-24) * abstract * | 11,12,14 | |
| A | * figure 1 * | 13 | |

-/--

The present search report has been drawn up for all claims

| Place of search | Date of completion of the search | Examiner |
|---|---|---|
| MUNICH | 7 May 2004 | Lopez-Carrasco, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**European Patent Office**

## EUROPEAN SEARCH REPORT

**Application Number**

EP 03 01 0594

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | PATENT ABSTRACTS OF JAPAN vol. 2000, no. 12, 3 January 2001 (2001-01-03) & JP 2000 266787 A (HITACHI LTD;TOKYO ELECTRIC POWER CO INC:THE), 29 September 2000 (2000-09-29) * abstract * | 13 | |
| A | PATENT ABSTRACTS OF JAPAN vol. 1996, no. 11, 29 November 1996 (1996-11-29) & JP 08 178968 A (HOYA CORP;TOKYO ELECTRIC POWER CO INC:THE), 12 July 1996 (1996-07-12) * abstract * | 13 | |

TECHNICAL FIELDS
SEARCHED (Int.Cl.7)

The present search report has been drawn up for all claims

| Place of search | Date of completion of the search | Examiner |
|---|---|---|
| MUNICH | 7 May 2004 | Lopez-Carrasco, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

Application Number

EP 03 01 0594

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

| | | |
|---|---|---|
| **European Patent Office** | **LACK OF UNITY OF INVENTION SHEET B** | **Application Number** EP 03 01 0594 |

The Search Division considers that the present European patent application does not comply with the requirements of unity of invention and relates to several inventions or groups of inventions, namely:

1. Claims: 1-10

   Lids adapted for fixation to a housing in a current measurement device

2. Claims: 11-14

   Method of calibrating a system for measuring a high voltage current

**ANNEX TO THE EUROPEAN SEARCH REPORT
ON EUROPEAN PATENT APPLICATION NO.**  EP 03 01 0594

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2004

| Patent document cited in search report | | Publication date | Patent family member(s) | | Publication date |
|---|---|---|---|---|---|
| JP 10123226 | A | 15-05-1998 | NONE | | |
| US 6349165 | B1 | 19-02-2002 | AU | 2423301 A | 18-06-2001 |
| | | | TW | 463064 B | 11-11-2001 |
| | | | WO | 0142837 A1 | 14-06-2001 |
| US 5486754 | A | 23-01-1996 | AU | 3361993 A | 01-09-1993 |
| | | | CA | 2128735 A1 | 05-08-1993 |
| | | | DE | 69328825 D1 | 13-07-2000 |
| | | | DE | 69328825 T2 | 18-01-2001 |
| | | | EP | 0624252 A1 | 17-11-1994 |
| | | | WO | 9315410 A1 | 05-08-1993 |
| | | | JP | 7503318 T | 06-04-1995 |
| US 4676589 | A | 30-06-1987 | JP | 61116303 A | 03-06-1986 |
| US 6265862 | B1 | 24-07-2001 | AT | 205941 T | 15-10-2001 |
| | | | CA | 2260055 A1 | 15-01-1998 |
| | | | CN | 1230258 A | 29-09-1999 |
| | | | WO | 9801763 A1 | 15-01-1998 |
| | | | DE | 59704678 D1 | 25-10-2001 |
| | | | EP | 0910801 A1 | 28-04-1999 |
| | | | JP | 2002514297 T | 14-05-2002 |
| JP 2000266787 | A | 29-09-2000 | NONE | | |
| JP 08178968 7 | A | | NONE | | |

EPO FORM P0459

For more details about this annex : see Official Journal of the European Patent Office, No. 12/82